# EUROPEAN PATENT APPLICATION

(11) **EP 4 207 281 A1**
(43) Date of publication of application: **05.07.2023**
(21) Application number: 22216907.0
(22) Date of filing: 28.12.2022
(51) Int. Cl.: H01L 25/16, H01L 23/34, H01L 25/07

(54) **PACKAGING STRUCTURE FOR POWER MODULE, PACKAGING METHOD AND ELECTRIC VEHICLE**

(30) Priority: 29.12.2021 CN 202111642378
(71) Applicant: XPT EDS (Hefei) Co., Ltd., Hefei City, Anhui 230601 (CN)
(72) Inventor: CAO, Haiyang, Jiading Shanghai (CN); LI, Daohui, Jiading Shanghai (CN); QI, Fang, Jiading Shanghai (CN); ZHAO, Zihao, Jiading Shanghai (CN); ZENG, Pin, Jiading Shanghai (CN)
(74) Representative: Vossius & Partner Patentanwälte Rechtsanwälte mbB

(57) **Abstract**

The disclosure relates to a packaging structure for a power module, a packaging method and an electric vehicle. The packaging structure includes: a circuit board (10); at least one power chip (20), where each power chip is fastened on the circuit board, and each power chip is integrated with a sensor (21) that is capable of detecting a working state of the power chip; and a signal chip (30), where the signal chip is fastened on the circuit board and separated from the power chip, a compiling program is preset in the signal chip, the signal chip is in a communication connection with each sensor, and the signal chip is configured to be capable of being in a communication connection with a predetermined device, so as to output working state data of each power chip to the predetermined device. By detecting the working state of each power chip, the power chip can be protected precisely in real time. The signal chip serves as a connection medium between the sensor and the predetermined device, to reduce a quantity of pins, thereby avoiding generation of an excessively high parasitic inductance.

## Description

### Technical Field

The disclosure relates to the field of vehicle technologies, and specifically, to a packaging structure for a power module, a packaging method and an electric vehicle.

### Background Art

As modern science and technologies advance, electric vehicles are gradually used in the life of people. Electric vehicles are vehicles that are powered by onboard batteries, use electric motors to drive wheels to move, and conform to related requirements of road traffic and safety laws and regulations. Depending on power sources, electric vehicles are classified into pure electric vehicles, hybrid vehicles, fuel cell vehicles, and the like. Compared with conventional fuel vehicles, electric vehicles have many advantages such as zero emission, low energy consumption, and low noise, and therefore become popular among more and more users.

A power module is one of core components of an electric vehicle. A power module may package a plurality of power chips (for example, an insulated gate bipolar transistor (IGBT), a fast recovery diode (FRD), and a metal-oxide-semiconductor field-effect transistor (MOSFET)) into an entire module, and is externally connected to a grid driving circuit board and a control unit to conduct bidirectional conversion between a direct current (DC) and an alternating current (AC), thereby driving the motor to move with electric energy of an onboard battery. The power module is typically manufactured through a packaging process. A packaging structure not only can function to install, fasten, seal and protect the power chip, but also can provide a stable electrical insulation environment and heat dissipation channel for the power chip and enhance the electrical heat performance, thereby ensuring that the power chip has a high current, a high power and high reliability.

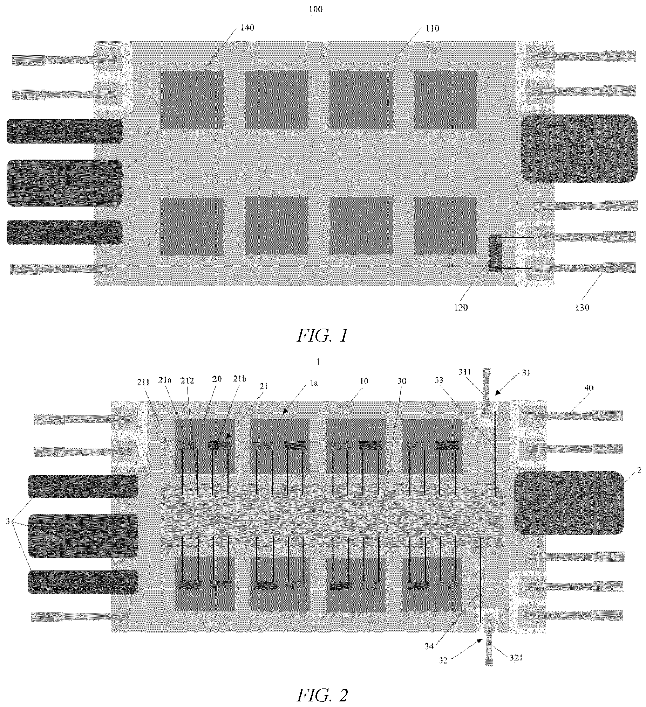

Current and temperature are important working state data of the power module. An excessively high working current or an excessively high working temperature not only affects the performance of the power module, but also may damage the power module and reduce the service life of the power module. Thus, how to precisely obtain the working state data of the power module in real time is crucial to development and usage of the power module. FIG. 1 is a schematic structural diagram of a packaging structure in the prior art. As shown in FIG. 1, to obtain the working state data of the power module, according to the prior art, a sensor 120 is typically installed at a certain position (for example, on a direct bonding copper (DBC) board 110) of a packaging structure 100, and is connected to pins 130 of the packaging structure by means of wire bonding, so as to transmit working current data or working temperature data detected by the sensor 120. This method is simple in structure and easy to operate. However, only the working state data of the entire power module can be detected, and working state data of each power chip 140 cannot be precisely detected.

Thus, a new technical solution is required in the art to solve the above problem.

### Summary of the Disclosure

In order to solve the foregoing problem in the prior art, namely, to solve the technical problem in the prior art that the working state of each power chip cannot be precisely detected, the disclosure provides a packaging structure for a power module. The packaging structure includes: a circuit board; at least one power chip, where each power chip is fastened on the circuit board, and each power chip is integrated with a sensor that is capable of detecting a working state of the power chip; and a signal chip, where the signal chip is fastened on the circuit board and separated from the power chip, a compiling program is preset in the signal chip, the signal chip is in a communication connection with each sensor, and the signal chip is configured to be capable of being in a communication connection with a predetermined device, so as to output working state data of each power chip to the predetermined device.

The packaging structure for the power module provided by the disclosure includes the circuit board, the at least one power chip and the signal chip. Each power chip is fastened on the circuit board. Each power chip is integrated with a sensor that is capable of detecting a working state of the power chip. By integrating the sensor on each power chip, it is convenient to precisely detect the working state of each power chip in real time. This provides protective measures such as overload protection and overheat protection for the power chip, thereby ensuring normal operation of the power chip. The signal chip separated from the power chip is further provided on the circuit board. The compiling program is preset in the signal chip. In addition, the signal chip is configured to be in a communication connection with each sensor and the predetermined device respectively, so that the working state data of each power chip can be conveniently transmitted to the predetermined device by the signal chip. Further, instead of directly connecting each sensor to the predetermined device, the signal chip is disposed as a connection medium between each sensor and the predetermined device, so that a quantity of pins in the power module can be reduced. Therefore, the structure of the power module is simpler, and this prevents generation of an excessively high parasitic inductance and degradation of the performance of the power module.

In the foregoing preferred technical solutions of the packaging structure for the power module, the sensor includes a temperature sensor and/or a current sensor. Through the above setting, different types of sensors can be flexibly disposed on the power chip, so as to meet detection requirements.

In the foregoing preferred technical solutions of the packaging structure for the power module, the signal chip is provided with an input end and an output end, the input end is connected to an external driving power supply, and the output end is connected to the predetermined device. By providing the input end and the output end on the signal chip, the working state data of each power chip can be conveniently read, and the structure of the entire packaging structure can be simplified, thereby facilitating processing and manufacturing.

In the foregoing preferred technical solutions of the packaging structure for the power module, the power chip and the signal chip are fastened on the circuit board by means of silver sintering, welding or bonding. Through the above setting, a processing manner can be flexibly selected according to an actual requirement, so as to meet different processing requirements.

In the foregoing preferred technical solutions of the packaging structure for the power module, the sensor is in the communication connection with the signal chip by means of wire bonding. By the means of wire bonding, a stable communication connection can be established between the sensor and the signal chip. In addition, the wire bonding process is relatively mature, which can reduce the processing costs accordingly.

In order to solve the foregoing problem in the prior art, namely, to solve the technical problem in the prior art that the working state of each power chip cannot be precisely detected, the disclosure further provides a packaging method. The packaging method is applied to manufacture the power module as described in any of the foregoing solutions, and the packaging method includes:
integrating, on each power chip, a sensor that is capable of detecting a working state of the power chip;
presetting a compiling program in a signal chip to compile data detected by the sensor;
fastening the signal chip and at least one power chip on a circuit board at intervals from one another;
establishing a communication connection between each sensor and the signal chip, and establishing a communication connection between the signal chip and a predetermined device, so as to output working state data of each power chip to the predetermined device by the signal chip. The sensor integrated on each power chip can conveniently detect the working state of the power chip. This provides protective measures such as overload protection and overheat protection for the power chip, which ensures normal operation of the power chip, thereby enhancing the reliability of the entire power module. In addition, the signal chip is disposed to output the working state data detected by each sensor to the predetermined device, so that this can simplify the structure and prevent generation of an excessively high parasitic inductance, thereby enhancing the overall performance of the entire power module.

In the foregoing preferred technical solutions of the packaging method, the sensor includes a temperature sensor and/or a current sensor. Through the above setting, different types of sensors can be flexibly disposed on the power chip, so as to meet detection requirements.

In the foregoing preferred technical solutions of the packaging method, the power chip and the signal chip are fastened on the circuit board by means of silver sintering, welding or bonding. Through the above setting, a processing manner can be flexibly selected according to an actual requirement, so as to meet different processing requirements.

In the foregoing preferred technical solutions of the packaging method, the sensor is in the communication connection with the signal chip by means of wire bonding. By the means of wire bonding, a stable communication connection can be established between the sensor and the signal chip. In addition, the wire bonding process is relatively mature, which can reduce the processing costs accordingly.

In order to solve the foregoing problem in the prior art, namely, to solve the technical problem in the prior art that the working state of each power chip cannot be precisely detected, the disclosure further provides an electric vehicle. The electric vehicle includes: a power module, where the power module has the packaging structure as described in any of the foregoing solutions, or is manufactured using the packaging method as described in any of the foregoing solutions. Through the above setting, the vehicle of the disclosure can conveniently obtain the working state of each power chip, so as to timely and accurately provide protective measures such as overload protection and overheat protection for the power chip. This ensures the normal operation of the power module, thereby improving running performance and the service life of the entire vehicle.

### Brief Description of the Drawings

Preferred implementations of the disclosure are described below with reference to drawings. Among the drawings:
FIG. 1 is a schematic structural diagram of a packaging structure in the prior art;
FIG. 2 is a schematic structural diagram of a first embodiment of a packaging structure for a power module of the disclosure;
FIG. 3 is a schematic structural diagram of a second embodiment of a packaging structure for a power module of the disclosure; and
FIG. 4 is a schematic flowchart of an embodiment of a packaging method of the disclosure.

### List of reference numerals:

100. Packaging structure in the prior art; 110. DBC board in the prior art; 120. Sensor in the prior art; 130. Pin in the prior art; 140. Power chip in the prior art; 1. Packaging structure; 1a. Power module; 10. Circuit board; 20. Power chip; 21. Sensor; 21a. Current sensor; 21b. Temperature sensor; 211. First lead wire; 212. Second lead wire; 30. Signal chip; 30a. First signal chip; 30b. Second signal chip; 31. Input end; 311. Input pin; 32. Output end; 321. Output pin; 33. Third lead wire; 34. Fourth lead wire; 40. Pin; 2. AC module; and 3. DC module.

### Detailed Description of Embodiments

The preferred implementations of the disclosure are described below with reference to the accompanying drawings. Those skilled in the art should understand that these implementations are only used to explain the technical principles of the disclosure, and are not intended to limit the scope of protection of the disclosure.

It should be noted that, in the description of the disclosure, the terms that indicate the direction or positional relationship, such as "upper", "lower", "left", "right", "inner", and "outer", are based on the direction or positional relationship shown in the figures, which is merely for ease of description instead of indicating or implying that the apparatus or element must have a particular orientation and be constructed and operated in a particular orientation, and therefore, should not be construed as limiting the disclosure. Furthermore, the terms "first" and "second" are used for descriptive purposes only, and cannot be understood as indicating or implying relative importance.

In addition, it should also be noted that, in the description of the disclosure, the terms "dispose" and "connect" should be interpreted in a broad sense unless explicitly defined and limited otherwise. For example, a connection may be a fastened connection, a detachable connection, or an integral connection; and may be a direct connection, an indirect connection by means of an intermediary, or internal communication between two elements. For a person skilled in the art, the specific meanings of the terms described above in the disclosure can be interpreted according to the specific conditions.

In order to solve the technical problem in the prior art that the working state of each power chip cannot be precisely detected, the disclosure provides a packaging structure 1 for a power module 1a. The packaging structure 1 includes: a circuit board 10; at least one power chip 20, where each power chip 20 is fastened on the circuit board 10, and each power chip 20 is integrated with a sensor 21 that is capable of detecting a working state of the power chip; and a signal chip 30, where the signal chip 30 is fastened on the circuit board 10 and separated from the power chip 20, a compiling program is preset in the signal chip 30, the signal chip 30 is in a communication connection with each sensor 21, and the signal chip 30 is configured to be capable of being in a communication connection with a predetermined device, so as to output working state data of each power chip 20 to the predetermined device.

FIG. 2 is a schematic structural diagram of a first embodiment of a packaging structure for a power module of the disclosure. As shown in FIG. 2, in one or more embodiments, a packaging structure 1 for a power module 1a of the disclosure includes a circuit board 10, power chips 20, a signal chip 30, pins 40, and other components.

Continuing to refer to FIG. 2, in one or more embodiments, the circuit board 10 is a DBC board. The DBC board has the properties of ceramic such as high thermal conductivity, high electrical insulation, high mechanical strength, and low expansion, and has the properties of oxygen-free copper such as high electrical conductivity and excellent welding performance. Alternatively, the circuit board 10 is a printed circuit board (PCB) or any other suitable circuit board.

Continuing to refer to FIG. 2, in one or more embodiments, eight power chips 20 spaced apart from one another are fastened on the circuit board 10. Based on the orientation shown in FIG. 2, the eight power chips are evenly divided into the upper row and the lower row, and each row includes four power chips that are evenly spaced from one another, so that the packaging structure 1 has a symmetrical and regular structure. Each power chip 20 may be an IGBT chip, an FRD chip, a MOSFET chip or any other suitable power chip. Each power chip 20 may have the same structure and function. Alternatively, the power chips 20 may be configured to have different structures or functions according to actual requirements. In one or more embodiments, the power chips 20 are configured to be fastened on the circuit board 10 by means of silver sintering, so as to implement a stable fastened connection. Alternatively, the power chips 20 may be fixedly connected by welding, bonding or other suitable means. Further, a quantity of power chips 20 may be configured to any suitable value greater or less than 8, such as 1, 2, 9, or 10 according to actual requirements.

Continuing to refer to FIG. 2, in one or more embodiments, each power chip 20 is integrated with a sensor 21 that is capable of detecting a working state of the power chip. Each sensor 21 has two lead wires: a first lead wire 211 and a second lead wire 212, so as to transmit a working state signal detected by the sensor 21 to the signal chip 30. In one or more embodiments, each power chip 20 is integrated with one current sensor 21a and one temperature sensor 21b, to simultaneously detect a working current and a working temperature of the power chip. The current sensor 21a is connected in series to the corresponding power chip 20, to detect a working current passing through the power chip 20. The current sensor 21a may be a Hall current sensor or any other suitable current sensor. The temperature sensor 21b is configured to abut against a surface of the corresponding power chip 20, to detect a working temperature of the power chip 20. The temperature sensor 21b may be a thermistor-type temperature sensor, a thermocouple-type temperature sensor or any other suitable temperature sensor. Alternatively, each power chip 20 may be configured to be integrated with only one current sensor 21a or only one temperature sensor 21b.

Continuing to refer to FIG. 2, in one or more embodiments, one signal chip 30 is disposed between the two rows of power chips 20. The signal chip 30 is an integrated circuit (IC) chip or any other suitable chip. The signal chip 30 may be fastened on the circuit board 10 by silver sintering, welding, bonding or other suitable means. As shown in FIG. 2, the current sensor 21a and the temperature sensor 21b on each power chip 20 are configured to be in communication connections with the signal chip 30 by means of wire bonding, so that the packaging structure 1 is more compact and has a smaller volume. Specifically, the first lead wire 211 and the second lead wire 212 of each current sensor 21a and the first lead wire 211 and the second lead wire 212 of each temperature sensor 21b are all connected to the signal chip 30. Through the above setting, each sensor 21 and the signal chip 30 may be in a stable communication connection. In order to conveniently transmit the working state data detected by the current sensor 21a and the temperature sensor 21b to a predetermined device (not shown in the figure) and make the working state data recognizable by the predetermined device, a compiling program is preset in the signal chip 30. The signal chip 30 has an input end 31 and an output end 32. The input end 31 is configured to be connected to an external driving power supply (not shown in the figure), and the output end 32 is configured to be connected to the predetermined device, so that after the external driving power supply is turned on, the signal chip 30 works, to output the working state of the corresponding power chip 20 detected by each sensor 21 to the predetermined device. Specifically, an input pin 311 is provided on the input end 31, so as to be connected to the external driving power supply. An output pin 321 is provided on the output end 32, so as to be connected to the predetermined device. The signal chip 30 is connected to the input pin 311 through a third lead wire 33, and is connected to the output pin 321 through a fourth lead wire 34.

Continuing to refer to FIG. 2, the packaging structure 1 further has a plurality of pins 40, so as to be connected to an AC module 2 and a DC module 3, so that an alternating current of the AC module 2 may be converted into a direct current of the DC module 3 by the packaging structure 1. In one or more embodiments, the packaging structure 1 is further connected to a protection circuit (not shown in the figure) through a pin 40, so that overload protection and/or overheat protection may be performed on each power chip 20 according to working state data of the power chip detected by the sensor 21, thereby ensuring normal operation of the power module 1a.

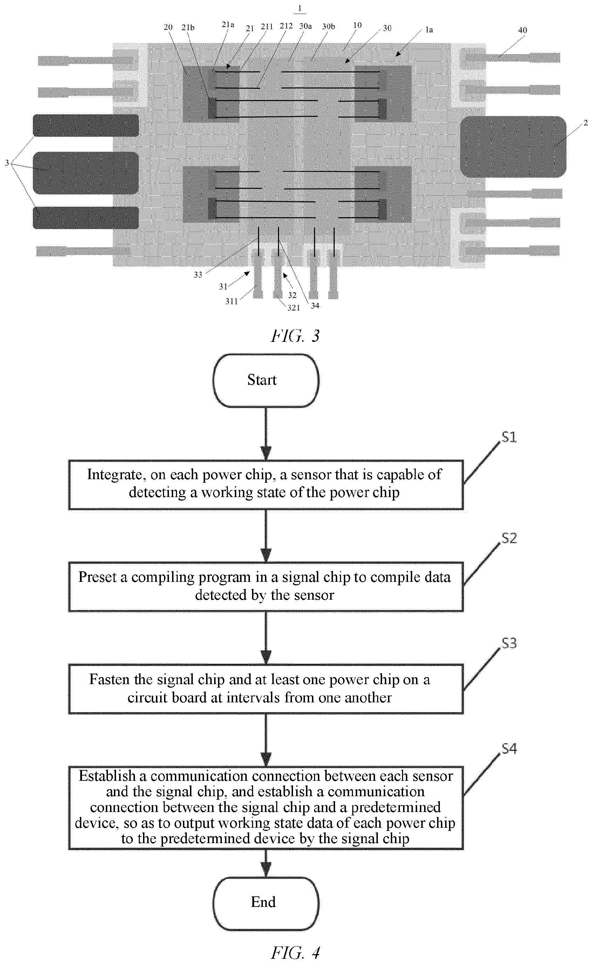

FIG. 3 is a schematic structural diagram of a second embodiment of a packaging structure for a power module of the disclosure. As shown in FIG. 3, in one or more embodiments, the packaging structure 1 for the power module of the disclosure includes a circuit board 10, four power chips 20 fastened on the circuit board 10, two signal chips 30 (based on the orientation shown in FIG. 3, respectively a first signal chip 30a on the left side and a second signal chip 30b on the right side) located between the four power chips 20, pins 40, and other components. Each power chip 20 is integrated with one current sensor 21a and one temperature sensor 21b. Each current sensor 21a is connected to the first signal chip 30a through a first lead wire 211 and a second lead wire 212, and each temperature sensor 21b is connected to the second signal chip 30b through a first lead wire 211 and a second lead wire 212. Either of the first signal chip 30a and the second signal chip 30b has an input end 31 and an output end 32 that are opposite to each other. Either of the first signal chip 30a and the second signal chip 30b is configured to be connected to an input pin 311 of the input end 31 through a third lead wire 33, and connected to an output pin 321 of the output end 32 through a fourth lead wire 34. It should be noted that other parts not mentioned in the second embodiment may be configured in the same way as that in the first embodiment, and will not be described in detail herein.

In order to solve the technical problem in the prior art that the working state of each power chip cannot be precisely detected, the disclosure provides a packaging method. The packaging method may be applied to manufacture the power module 1a as described in any of the foregoing embodiments. In one or more embodiments, after the packaging method starts, step S1 is first performed, namely, integrating, on each power chip 20, the sensor 21 that is capable of detecting a working state of the power chip. In one or more embodiments, the sensor 21 is the current sensor 21a, to detect a working current of the power chip 20. Alternatively, the sensor 21 is the temperature sensor 21b, to detect a working temperature of the power chip 20. Alternatively, the sensor 21 includes the current sensor 21a and the temperature sensor 21b, to simultaneously detect the working current and the working temperature of the power chip 20. Next, step S2 is performed, namely, presetting a compiling program in the signal chip 30 to compile data detected by the sensor 21. An IC chip is used as the signal chip 30, so that the compiling program can be conveniently imported into the signal chip. The compiling program may be programed by specific compiling software, and then the programed compiling software is imported to the signal chip 30 by a programming device and programming software. It should be noted that step S 1 and step S2 may be performed simultaneously or separately (for example, first step S 1 is performed and then step S2 is performed, or first step S2 is performed and then step S1 is performed). Then, the packaging method proceeds to step S3, namely, fastening the signal chip 30 and at least one power chip 20 on the circuit board 10 at intervals from one another. A fastening manner includes but is not limited to silver sintering, welding, bonding, and the like. A quantity of power chips 20 may be adjusted according to an actual requirement, such as 1, 2, 4, or 8. The power chips 20 may be one or more types of chips such as an IGBT chip, an FRD chip and a MOSFET chip. After step S3 is completed, the packaging method proceeds to step S4, namely, establishing a communication connection between each sensor 21 and the signal chip 30, and establishing a communication connection between the signal chip 30 and a predetermined device, so that the working state data of each power chip 20 may be output to the predetermined device by the signal chip 30. Each sensor 21 and the signal chip 30 may be connected through two lead wires (namely, the first lead wire 211 and the second lead wire 212). The signal chip 30 is connected to the input pin 311 of the input end 31 through the third lead wire 33, and is connected to the output pin 321 of the output end 32 through the fourth lead wire 34.

The disclosure further provides an electric vehicle (not shown in the figure). The electric vehicle includes a power module 1a, where the power module 1a uses the packaging structure 1 as described in any of the foregoing embodiments, or is manufactured using the packaging method as described in any of the foregoing embodiments. The electric vehicle further includes, but is not limited to, an onboard battery, a drive motor, a charging plug, and other components. The electric vehicle may drive the drive motor to move with electric energy of the onboard battery, so as to provide kinetic energy for the vehicle to move.

Heretofore, the technical solutions of the disclosure have been described with reference to the preferred embodiments shown in the accompanying drawings. However, those skilled in the art can readily understand that the scope of protection of the disclosure is apparently not limited to these specific embodiments. Those skilled in the art can make equivalent changes or substitutions to the related technical features without departing from the principle of the disclosure, and all the technical solutions with such changes or substitutions shall fall within the scope of protection of the disclosure.

## Claims

1. A packaging structure for a power module, wherein the packaging structure comprises:
a circuit board;
at least one power chip, wherein each power chip is fastened on the circuit board, and each power chip is integrated with a sensor that is capable of detecting a working state of the power chip; and
a signal chip, wherein the signal chip is fastened on the circuit board and separated from the power chip, a compiling program is preset in the signal chip, the signal chip is in a communication connection with each sensor, and the signal chip is configured to be capable of being in a communication connection with a predetermined device, so as to output working state data of each power chip to the predetermined device.

2. The packaging structure for a power module according to claim 1, wherein the sensor comprises a temperature sensor and/or a current sensor.

3. The packaging structure for a power module according to claim 1 or 2, wherein the signal chip is provided with an input end and an output end, the input end is connected to an external driving power supply, and the output end is connected to the predetermined device.

4. The packaging structure for a power module according to claim 1, 2, or 3, wherein the power chip and the signal chip are fastened on the circuit board by means of silver sintering, welding or bonding.

5. The packaging structure for a power module according to any one of claims 1 to 4, wherein the sensor is in the communication connection with the signal chip by means of wire bonding.

6. A packaging method, wherein the packaging method is applied to manufacture the power module according to any one of claims 1 to 5, and the packaging method comprises:
integrating, on each power chip, a sensor that is capable of detecting a working state of the power chip;
presetting a compiling program in a signal chip to compile data detected by the sensor;
fastening the signal chip and at least one power chip on a circuit board at intervals from one another;
establishing a communication connection between each sensor and the signal chip, and establishing a communication connection between the signal chip and a predetermined device, so as to output working state data of each power chip to the predetermined device by the signal chip.

7. The packaging method according to claim 6, wherein the sensor comprises a temperature sensor and/or a current sensor.

8. The packaging method according to claim 6 or 7, wherein the power chip and the signal chip are fastened on the circuit board by means of silver sintering, welding or bonding.

9. The packaging method according to claim 6, 7, or 8, wherein the sensor is in the communication connection with the signal chip by means of wire bonding.

10. An electric vehicle, wherein the electric vehicle comprises:
a power module, wherein the power module has the packaging structure according to any one of claims 1 to 5, or is manufactured using the packaging method according to any one of claims 6 to 9.
